(19) 
Europäisches
Patentamt
European
Patent Office
Office européen
des brevets

(11) **EP 2 330 232 A1**

(12) **EUROPEAN PATENT APPLICATION**

(43) Date of publication:
**08.06.2011 Bulletin 2011/23**

(51) Int Cl.:
**C23C 16/24** *(2006.01)*          **C23C 16/44** *(2006.01)*
**C23C 16/46** *(2006.01)*          **C01B 33/035** *(2006.01)*

(21) Application number: **10002031.2**

(22) Date of filing: **26.02.2010**

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**
Designated Extension States:
**AL BA RS**

(30) Priority: **02.12.2009 KR 20090118543**

(71) Applicant: **Woongjin polysilicon Co., Ltd.**
**Cheongni-myeon**
**Sangju-si, Gyeongsangbukdo**
**742-831 (KR)**

(72) Inventors:
• **Lee, Jong Gyu**
  **Yuseong-gu**
  **Daejeon, 305-500 (KR)**

• **Kim, Jong Rock**
  **Cheongwon-gun**
  **Chungcheongbuk-do, 363-852 (KR)**
• **Lee, Sang Woo**
  **Dalseo-gu**
  **Daegu, 704-370 (KR)**
• **Winterton, Lyle C.**
  **Sangiu-si**
  **Gyeongsangbuk-do, 742-090 (KR)**

(74) Representative: **Manitz, Finsterwald & Partner**
**GbR**
**Postfach 31 02 20**
**80102 München (DE)**

(54) **CVD reactor with energy efficient thermal-radiation shield**

(57)     A Siemens type CVD reactor device is provided. One or more radiation shields (20) are disposed between a rod filament (34) and a cooled wall (30) in the reactor. The radiation shield absorbs radiant heat emanating from the heated polysilicon rod during the CVD process, gets heated above 400°C, re-radiate the absorbed heat toward both of the polysilicon rod and the cooled wall, so as to provide thermal shielding effect to the cooled wall. The net energy loss of the polysilicon rod is reduced as much as the amount of energy emitted toward the polysilicon rod from the radiation shield, such that considerable amount of electrical energy of the CVD reactor is reduced and saved. The energy reduction rate goes up much higher if using multiple layered radiation shields, low shielding emissivity, and low thermal conductivity together. The purity of the manufactured polysilicon can be maintained by using thermal shielding material that is stable in a high temperature such as graphite, silicon carbide-coated graphite, and silicon.

Figure 2

EP 2 330 232 A1

**Description**

[Technical Field]

The invention relates to an improvement of a CVD reactor and more specifically to an art to improve the productivity of polysilicon rods as well as to lower the costs for producing them by reducing electrical energy loss in Siemens CVD reactors.

[Background Art]

Polycrystalline silicon, or polysilicon, is a critical raw material for the electronics industry. It is the starting material for production of single and multi-crystal silicon ingots for the semiconductor and photovoltaic industries. Semiconductor grade polysilicon contains electronically-active impurities in the parts per billion or parts per trillion ranges.

Generally, polysilicon rods are made by the pyrolytic decomposition of a gaseous silicon compound, such as mono-silane or a chlorosilane (e.g., trichlorosilane) on a rod-shaped, red-heated starter rod or filament made preferably from a silicon seed rod or, alternatively, from a high-melting point metal having good electrical conductivity such as tungsten or tantalum. The principles of the design of present state-of-the-art reactors for the pyrolysis of monosilane and chlorosilanes are set forth in, for example, U.S. Pat. Nos. 3,011,877; 3,147,141; 3,152,933 which are incorporated herein by reference as if set out in full. Reactors of this type are commonly referred to as Siemens reactors.

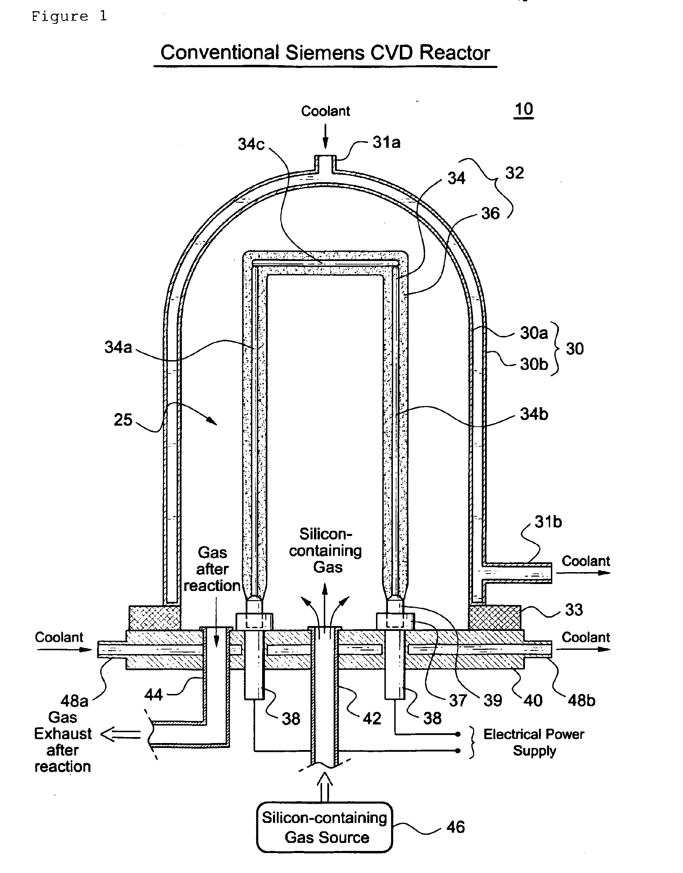

Fig. 1 shows a structure of a conventional Siemens CVD reactor. In general, a conventional Siemens CVD reactor device (10) is a processing container in which a bell-shaped reactor (or a bell jar) (30) is fixed on a base plate (40) with a gas-tight flange (33), and one or more reaction chambers (25) are provided inside. The bell-shaped reactor (30) comprises an outer jacket (30b) and an inner shell (30a), and since it is configured that coolant flows in between (a coolant input pipe (31a) and a coolant output pipe (31b) are connected to the outer jacket (30b)), the reactor's inner shell (30a) (referred as 'cooled wall' hereafter) is maintained at a state of a temperature lower than 200°C (100°C in a certain process) in the CVD process. The base plate (40) is connected to an input pipe (48a) and an output pipe (48b) for flowing coolant, so as to limit the temperature below a predetermined value. The base plate (40) also comprises a gas inlet (42) and a gas outlet (44). Silicon-containing gas compounds flow into the reaction chamber (25) through the gas inlet (42) connected to a silicon-containing gas source (46), and the gas after CVD reaction is discarded outside the reaction chamber (25) through the gas outlet (44). Also, two feedthroughs (38) extend from the outside of the base plate (40) into the reaction chamber (25), and each end portion of them is connected to an electrode (39) made of graphite, for example, while supported by a rod support (37). In the reaction chamber (25), more than one set of rod filaments (34) are provided. Specifically, one set of rod filaments (34) forms a hair-pin or U-shaped rod with two vertical rod filaments (34a, 34b) standing apart with an interval in the reaction chamber (25) and a horizontal rod filament (34c) connecting top end portions of the two vertical rod filaments (34a, 34b). And, each of bottom end portions of the two vertical rod filaments (34a, 34b) is connected to an external electrical power supply through an electrode (39) and the feedthrough (38), and thus the one set of rod filament (34) forms a complete electrical circuit.

In this conventional Siemens CVD reactor device (10), a current flows in the rod filament (34) through the feedthrough (38) and the electrode (39) for a CVD process, and silicon-containing gas compounds like monosilane, disilane, or chlorosilane, or mixture of such gases are supplied to the reaction chamber (25) from the silicon-containing gas source (46). Then, the rod filament (34) is heated and a pyrolysis of monosilane to form silicon and hydrogen as a by-product, or a chlorosilane which produces silicon and chloride-containing compounds such as HCl, $SiHCl_4$ or the like as well as hydrogen, is performed in a Siemens reactor (25). A mechanism for CVD deposition by the pyrolysis process may be represented with the following reaction formulas.

$$SiH_4 \dashrightarrow Si + 2H_2$$

$$SiHCl_3 + H_2 \longleftrightarrow Si + 3HCl$$

$$SiHCl_3 + HCl \longleftrightarrow SiCl_4 + H_2$$

As shown in the above, the polysilicon is produced by chemical vapor deposition (CVD) after heterogeneous decomposition of the monosilane or chlorosilane onto the glowing hot silicon rod filament (34). The diameter of a depositing polysilicon rod (36) increases until the desired size is achieved at which point the reactor device (10) is shut down, purged of its process gases from the reaction chamber (25), and the reactor (30) is opened for harvesting the polysilicon rod (32).

Currently only the Siemens process has the capability to produce semiconductor-grade polysilicon. But the Siemens process is also known as an energy intensive process and so the cost to produce semiconductor grade silicon using the Siemens process is relatively high. The electrical energy-cost to produce polysilicon in a Siemens reactor typically runs between 65 and 200 kWh/kg resulting in electrical energy being the single largest cost factor. Therefore, reducing the electrical energy-cost in producing polysilicon is closely related to competitivity of a polysilicon manufacturer. Energy from the red-heated rod (32) is lost via thermal-radiation directly to the surfaces of the cooled wall (30a), via convection to the process gases in the reaction chamber (25) and by conduction to the cooled rod supports (37) or electrodes (39). Especially, the thermal radiant losses directly to the cooled wall (30a) typically comprise 75% to 95% of the total energy losses. Therefore, it is required to find a way to reduce the thermal radiant energy loss effectively.

[Disclosure]

[Technical Problem]

There exists a mechanism for regulating thermal radiant energy referred to as 'cold reflection'. Thermal radiation is defined as radiant energy emitted by a medium by virtue of its temperature. The emission of thermal radiation is governed by the temperature of the emitting body (i.e. heated silicon rod (32)). When radiant energy impacts a surface medium, this energy can be either reflected by the medium, absorbed by the medium, or transmitted through the medium. If the incident medium is highly polished, radiation is primarily reflected. In pure reflection, the impacted medium does not absorb radiation, and therefore the medium temperature does not change. This is a "cold reflector". In the case of this "cold reflector" the reflected radiation is not thermal radiant energy.

US Patent 4,173,944 (Silver-plated vapor deposition chamber) to Koppl et al. teaches an example of a mechanism for reducing energy using such a cold reflector. Koppl et al. disclose a method of plating silver on the inner surface of the cooled wall (30a), that is, a surface of the inner shell (30a) that lies close to the silicon rod (32). Plating the inner surface of the cooled wall (30a) with reflective silver may be for reducing energy by increasing the wall reflectivity and reflecting the radiant energy from the polysilicon rod (32) in order to raise the efficiency of electrical energy. The silver-plated surface is formed as a part of the cooled wall (30a) which is relatively cooler yet some of the radiant energy incident on the silver-plated surface is constantly lost through the cooled wall (30a), and thus the silver-plated surface is maintained as a relatively cold surface (a little higher than the temperature of the cooled wall (30a)) all the time. Still, the silver-plated surface absorbs some radiant energy. But the silver-plated surface is unable to re-radiate the incident thermal radiation because it is relatively cold and contributes to energy efficiency merely by reflecting the thermal radiation incident on it. But, maintaining the reflectivity of the silver-plated surface of the cooled wall (30a) in a Siemens reactor as high as its initial state is difficult because of the harsh process environment and the process deposits precipitated onto the silver-plated cooled wall (30).

It is another burden to maintain the silver-plated surface of the cooled wall (30a) as a bright glossy surface in order to have a high reflectivity. In spite of such efforts, the lowering of the reflectivity of the silver-plated surface is unavoidable, and the reduction of electrical energy is abated. Also, the cooled wall (30a) is usually kept below a temperature of about 100°C (or 200°C), and if the temperature goes up above about 250°C (or 400°C) then impurities from the cooled wall (30a) may contaminate the reaction chamber (25). Because of this, the cooled wall (30a) must be kept below 250°C (or 400°C).

There had been other attempts for raising the energy efficiency in manufacturing polysilicon using Siemens CVD reactors. Some companies recover waste heat from the wall coolant in the cooled wall (30a) of the CVD reactor. But, such waste heat recovery requires relatively high coolant temperatures which in turn require hot reactor walls. But, because metals outgas impurities at high temperatures, hot metal walls are undesirable. Hot emitters could be designed by using internal insulation, but historically companies that produce polysilicon using the Siemens process hesitated to add anything to the interior of the reaction chamber (25) of the Siemens CVD reactor due to contamination concerns.

Another problem associated with high radiant energy loss is a steep radial temperature gradient from the surface to the center of the heated silicon rod. As energy is lost at the rod surface, the radial gradient through the center of the rod is increased to maintain the silicon rod surface at a temperature appropriate for process kinetics. In US Patent No. 6,221,155, Keck teaches that the amperage within electrically heated rods migrates toward the centers of the silicon rods because of the inverse temperature vs. resistivity behavior of silicon. Also, Keck teaches that the silicon rod skin acts as an insulator to energy generated within the rod core. This migration of amperage and the insulating effect of the rod skin cause the rod center to run hotter than the skin resulting in high tensile stresses at the center of the silicon rod upon cool down, which stresses result in brittle fracture when the stresses exceed the ultimate strength of the material. Further, Keck teaches that because rod internal stresses increase with increasing diameter large diameter silicon rods (greater than 150-mm) cannot be reliably grown using the Siemens CVD process without reducing the temperature gradient through the silicon rod.

The melting point of polysilicon is about 1414°C. If the silicon rod skin temperature is at the optimum temperature for the decomposition of trichlorosilane (about 1150°C) and the center of the polysilicon rod is elevated in temperature, occasionally when the polysilicon rod diameter becomes large, the center of the rod will reach melting point causing rod integrity failure. To avoid melting, often the skin surface temperature should be reduced when the silicon rod diameter is large. This reduction in skin temperature causes a loss in kinetic-rate-of-decomposition and a reduction in reactor capacity.

It is necessary to consider and solve the above problems for reducing energy in manufacturing polysilicon rod using the Siemens reactors. From these viewpoints, it is an object of the present invention to provide a CVD reactor device which can not only raise the energy efficiency by reducing electrical energy for manufacturing polysilicon rods, but also maintain the capability of energy reduction constantly even for extended operation.

Also, it is another object of the present invention to provide a CVD reactor device, which can reduce temperature gradient within the entire inside of the polysilicon rod by reducing net energy loss of the polysilicon rod during the CVD process and produce a polysilicon rod of large diameter by reducing tensile stresses.

Furthermore, it is still another object of the present invention to provide a CVD reactor device, which can reduce electrical energy consumption through processes that do not produce impurities contaminating the processing environment in the reaction chamber.

[Technical Solution]

To achieve the above objects, the inventors took hot emission into consideration as a mechanism to adjust the radiant energy. When radiant energy is absorbed by a non-reflecting medium, the medium becomes hot. As the temperature of this perfect radiator or "black-body" medium increases, it begins to emit thermal radiation according to the Stefan-Boltzmann law which is expressed as equation (1). Such medium is called "hot emitter".

$$q = \sigma A T^4 \qquad\qquad (1)$$

where q = Thermal radiation emitted from emitting body σ = Stefan-Boltzmann constant
A = Emitting body surface area
T = Absolute temperature of the emitting body.

Applicant checked through various means that the hot emitter mechanism is an efficient means for solving the problems, and succeeded in providing a CVD reactor that solves the above problems. According to an aspect of the present invention, a CVD reactor device comprises: a reaction container comprising one or more reaction chambers with a cooled wall; a plurality of electrodes extending into the reaction chambers; at least one rod filament having two ends connected to two different electrodes of the plurality of electrodes in the reaction chamber and being heated to a high temperature when a current flow through the two electrodes; a silicon-containing gas source that is connected to inside of the reaction chamber, supplies silicon-containing gas into the reaction chamber, and has polysilicon deposited on surfaces of the rod filament heated by a chemical vapor deposition process producing polysilicon rod; and a radiation shield disposed between the rod filament and the cooled wall and/or between the rod filament and the floor of the reaction chamber and shielding the radiant heat energy from the polysilicon rod from transferring to the cooled wall and/or to the floor of the reaction chamber.

The "hot emitter" thermal radiation shield (or shields), which is placed between the heated polysilicon rod and the cooled wall surfaces, intercepts the thermal radiation emanating from the polysilicon rods casting a shadow onto the cooled wall. As the gray-body shield absorbs the thermal radiant energy emanating from the polysilicon rod in the CVD process, its temperature increases. The "hot emitter" shield emits increasing quantities of thermal radiation as its temperature increases, some of the radiant heat toward the heated polysilicon rods and the rest of the radiant heat toward the cooled wall. The portion of the thermal radiation energy emitted toward the polysilicon rods reduces the rods net energy loss. The radiation shield is preferably kept at a temperature above 400°C during the CVD process. Especially, the temperature of a surface facing the heated polysilicon rod of the radiation shield is preferably kept above 400°C.

According to another aspect of the present invention, a CVD reactor device comprises: a reaction container forming a reaction chamber with a base plate and a cooled wall covering the base plate; an electrical power supply extending from outside of the reaction container into the reaction chamber through the base plate, being provided with a plurality of electrodes at end portions; at least one rod filament having two ends connected to two different electrodes of the plurality of electrodes of the electrical power supply in the reaction chamber so as to form a closed circuit and being heated to a high temperature when a current flow therein through the electrical power supply; a silicon-containing gas source that supplies silicon-containing gas into the reaction chamber through a gas input pipe and a gas output pipe connected from outside to inside of the reaction chamber, and has polysilicon deposited on surfaces of the rod filament heated by a chemical vapor deposition process to produce polysilicon rod; and a radiation shield disposed between the rod filament and the cooled wall and/or between the rod filament and the floor of the reaction chamber, covering at least a part of at least one of the cooled wall and the floor of the reaction chamber, and maintaining a temperature thereof above about 400°C by absorbing heat radiating from the polysilicon rod during the CVD reaction and reducing thermal energy loss of the polysilicon rod by re-radiating a part of the absorbed heat toward the polysilicon rod.

In the CVD reactor device, it is preferable that the radiation shield encloses the rod filament, and is installed so as to cover at least a part of surface of the cooled wall with respect to the cooled wall and so as to cover at least a part of the floor with respect to the floor (plate) of the reaction chamber.

The core of the polysilicon rod is elevated in temperature above that of the skin. Reducing energy loss of the polysilicon rod reduces the rod's radial thermal gradient and also the resulting tensile stresses at the rod core, allowing one to successfully grow polysilicon rods to a larger diameter. The production capacity of the Siemens CVD reactor increases as the polysilicon rod diameter increases.

It is more preferable that a plurality of hot emitter thermal radiation shields are installed in multiple layers. Multiple "hot emitter" thermal radiation shields (or multiple layers within a single shield) retain energy more efficiently than one single shield with only one layer. Each layer of the radiation shields contributes independently to rod-energy retention. When stacked in multiple layers, the plurality of radiation shields are preferably disposed loosely such that multiple gaps are provided between the multiple layers.

In installing the plurality of radiation shields, it is preferable that the plurality of radiation shields are disposed with structures of, viewing from the rod filament toward the cooled wall, a) being disposed with a plurality of layers having more than two layers overlapped, b) being disposed with single layers with intervals therebetween, and c) being disposed with mixed structures of the overlapped multiple layers and the separated single layers.

The hot emitter radiation shields are preferably made of material with low thermal conductivity. The radiation shields of considerable thickness and low thermal conductivity behave like thermal insulators by restricting heat transfer through the thickness of the radiation shield thereby causing the shield surface facing the thermal radiation source (that is, the heated polysilicon rod) to emit thermal radiation and thereby add to the overall energy conservation.

The radiation shield is preferably made to maintain its temperature above 400°C during the CVD reaction. Especially, the temperature of a surface of the radiation shield facing the heated polysilicon rod is preferably kept above 400°C during the CVD reaction.

The radiation shields are preferably disposed with intervals such that a minimal minute gap is provided against the cooled wall so as to function as a thermal resistance. However, the radiation shield may be installed to contact loosely the surface of the cooled wall such that a plurality of gaps (empty space) against the cooled wall are provided.

The radiation shield is preferably made to have thickness and thermal conductivity satisfying a condition of k/$\tau$ value below 3,000 watt/Kelvin. Here k is a thermal conductivity of the radiation shield, and $\tau$ a thickness of the radiation shield. If satisfying the condition, the radiation shield may be installed closely to the cooled wall such that there is no gap resistance to the thermal conductivity with the cooled wall.

The radiation shield is preferably made of material having a spectral emissivity of 0.05 ~ 1.0.

The radiation shield is preferably made of silicon, graphite, or silicon carbide (SiC). The material for the radiation shield is not limited to the above though. The radiation shield can be made of any one or combination of two or more selected from the group consisting of, including the above-mentioned materials, silicon carbide-coated material, silicon nitrides (nitrified silicons), silicon oxides, aluminum oxides, boron nitrides, molybdenum or molybdenum-based alloys, tungsten or tungsten-based alloys, tantalum or tantalum-based alloys, silica-based porous materials, aluminosilicate-based porous materials, gold-coated porous materials, gold-coated materials, platinum-coated porous materials, platinum-coated materials, silica-coated porous materials, silica-coated materials, silver-coated porous materials, silver-coated materials, and perlite.

The radiation shield reduces the thermal energy loss from the polysilicon rod by at least one of the following effects; thermal shielding effect by a hot emittance 400°C), shielding effect by multiple layers of radiation shields, shielding effect by a low emissivity of the radiation shield material, and insulating effect by reduction of thermal conductivity due to thickness. The efficiency of the shield is strongly dependent on its physical position within the reaction chamber. The shield must be placed in such a way that its source-facing surface (surface facing the heated polysilicon rod) is maintained hot (high temperature) by intercepting the thermal radiant energy leaving the heated rods.

[Advantageous Effects]

If radiation shields are installed between the polysilicon rod filament and the cooled wall in the Siemens CVD reactor as suggested by the present invention, the thermal loss from surface of the polysilicon in the reactor is reduced by blocking the thermal energy radiating from the heated filament rod toward the cooled wall. As a result, the net energy loss of the polysilicon rod is reduced, and the total electrical energy consumption of the CVD reactor can be reduced by the temperature control mechanism of the Siemens CVD reactor.

Additionally, by reducing the energy loss of the polysilicon rod, the temperature difference between the core and the surface of the polysilicon rod is reduced and the resulting tensile stress is reduced. Therefore, it is enabled to grow a polysilicon rod to a large diameter, increasing the productivity of the Siemens CVD reactor.

[Description of Drawings]

Fig. 1 is an axial view showing structure of a conventional Siemens CVD reactor;

Fig. 2 is an axial view showing structure of a CVD reactor with a radiation shield installed so as to cover entire surface of a cooled bell jar wall of the CVD reactor according to an embodiment of the present invention;

Fig. 3 is a cross-sectional view showing along line A-A of Fig. 2;

Fig. 4 is a cross-sectional view showing structure of a CVD reactor with a radiation shield installed so as to cover a part of the surface of a cooled wall of the CVD reactor according to another embodiment of the present invention;

Fig. 5 is an axial view showing structure of a CVD reactor with a multiple layered thermal radiation shield installed so as to cover a part of the surface of a cooled wall of the CVD reactor according to still another embodiment of the present invention;

Fig. 6 is a cross-sectional view showing along line B-B of Fig. 5;

Fig. 7 is a cross-sectional view showing structure of a CVD reactor with a radiation shield having 3 separated-layers installed so as to cover an entire or a part of inner surface of the reactor according to still another embodiment of the present invention;

Fig. 8 is a cross-sectional view showing a radiation shield having 3 loosely-overlapped-layers applied loosely to a surface of a cooled wall;

Fig. 9 is a graph illustrating a relationship between temperature of inner surface of a radiation shield and energy reduction rate;

Fig. 10 is a graph illustrating a relationship between features of a radiation shield and energy reduction rate;

Fig. 11 is an axial view showing structure of a CVD reactor with a radiation shield installed so as to cover a cooled wall and a floor of the reactor according to still another embodiment of the present invention; and

Fig. 12 is a plan view showing along line C-C of Fig. 11.

[Best Mode]

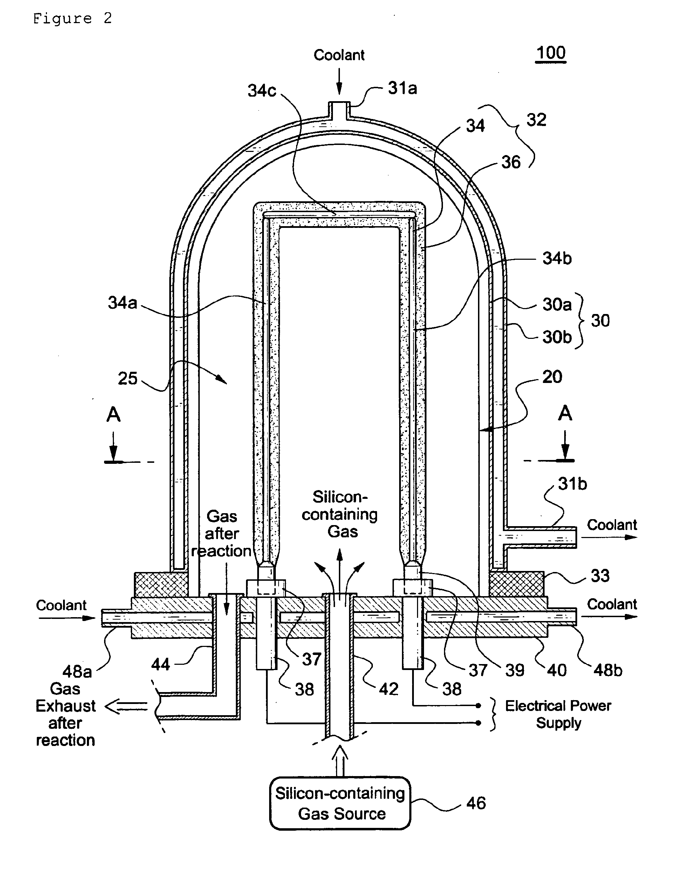

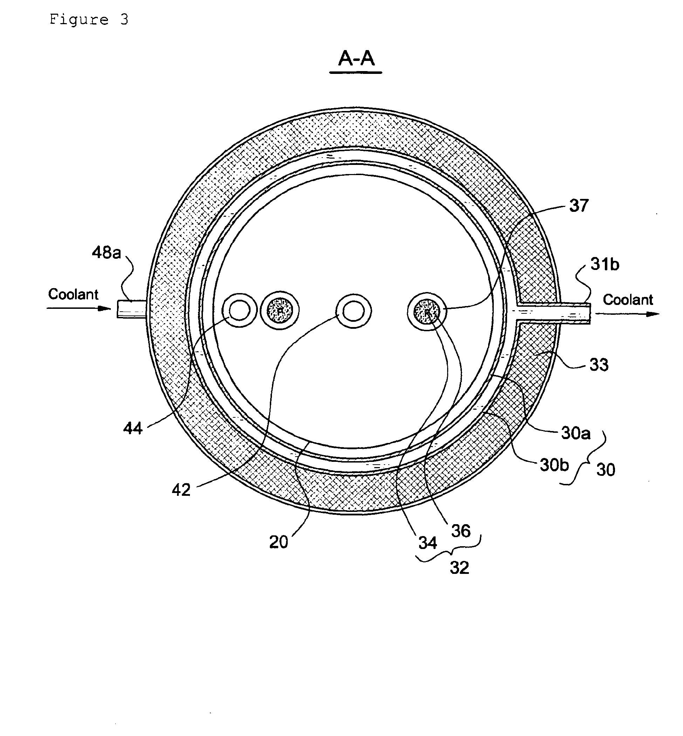

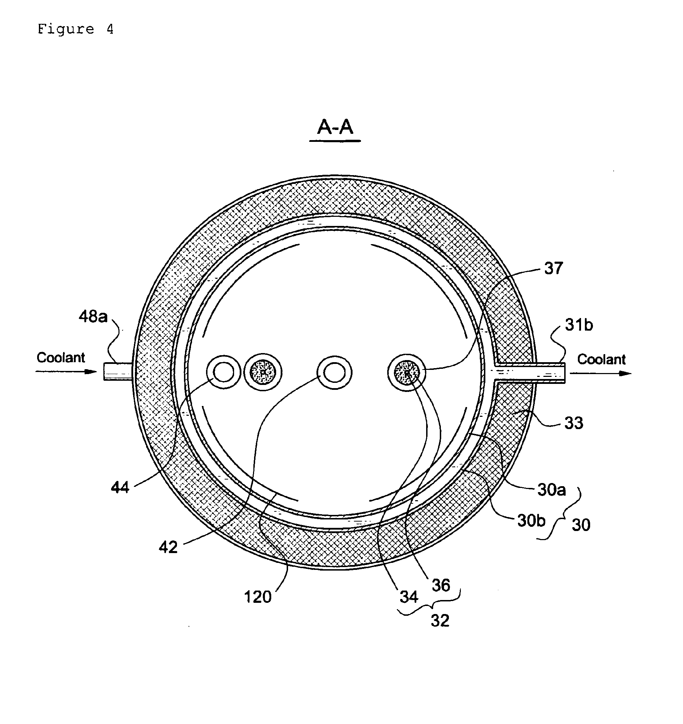

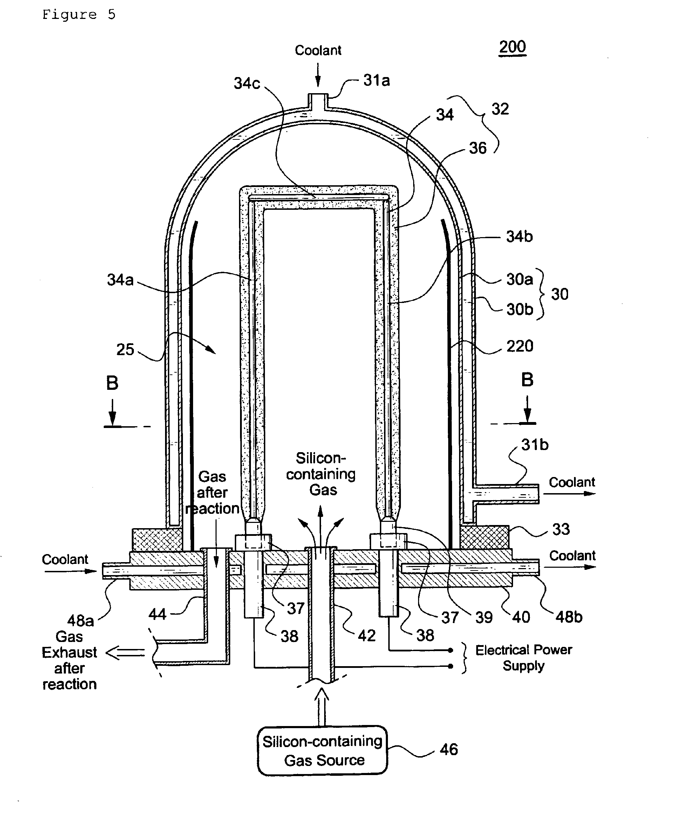

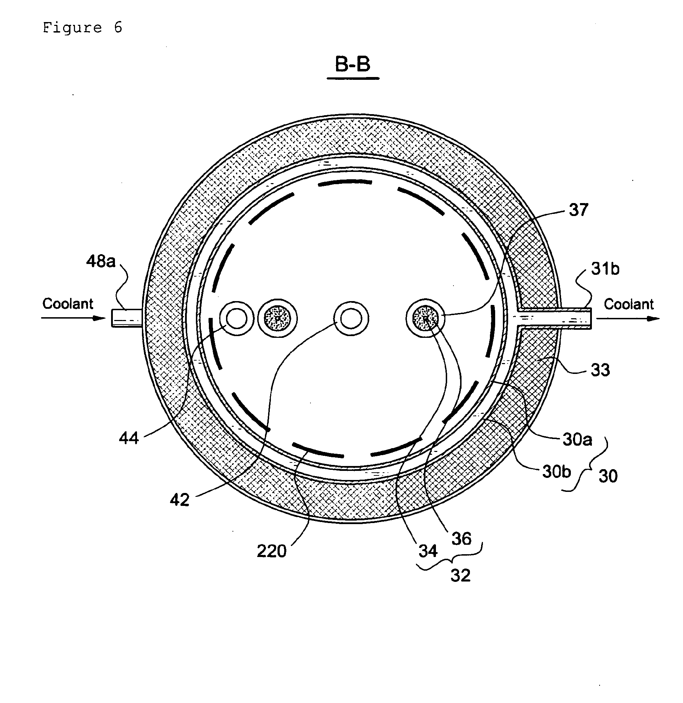

Fig. 2 is an axial view showing structure of a Siemens CVD reactor device (100) according to a first embodiment of the present invention. The CVD reactor device (100) further comprises a hot emitter radiation shield (or radiation shields) compared to a conventional CVD reactor device (10), and the structures other than a thermal radiation shield (20) are same. This hot emitter radiation shield (20) is installed between a polysilicon rod (32) (that is, rod filament (34)) and a cooled wall (30a) of the bell-shaped reactor (30). Fig. 3 is a cross-sectional view along the line A-A of Fig. 2. As illustrated, it is preferable that the radiation shield (20) encloses the rod filament (34) and covers the entire inner surface of the cooled wall (30a). However, the radiation shield (20) may be installed so as to cover just a part, not the whole, of the cooled wall (30a). For example, Fig. 4 shows that radiation shields (120) having four parts are installed so as to cover partially side portions of each quadrant, a first quadrant to a fourth quadrant (viewing from a center of the reaction chamber (25)). Also, as shown in Figs. 5 and 6 the radiation shield (220) can be installed so as to cover partially a side portion of the cooled wall (30a) but not to cover a top portion of the cooled wall (30a) (For example, the radiation shield (220) shown in Figs. 5 and 6 comprises multiple layers, which is represented by solid lines). In other structures, the radiation shield (220) can be installed so as to cover the entire side portions, but not the top portion of the cooled wall (30a). In addition, the radiation shield can be installed variously so as to cover a part of the cooled wall (30a). Irrespective of the structure as in the above, if the radiation shield is installed to cover at least a part of the cooled wall (30a), a radiation heat shielding effect corresponding to the covered area can be provided.

A "hot-emitter" thermal radiation shield (or shields) (20) intercepts the thermal radiation emanating from the polysilicon rods (32) and casts a shadow onto the cooled wall (30a) to provide heat shielding effect. The gray-body radiation shield (20) intercepts and absorbs the thermal radiant energy emanating from the polysilicon rod (32) causing a temperature in the reactor to rise. The "hot emitter" thermal radiation shield (20) emits increasing quantities of thermal radiation as its temperature increases, some toward the heated polysilicon rods (32) and some toward the cooled wall (30a). At some temperature below that of the heated polysilicon rods (32) and above that of the cooled wall (30a), the shield reaches an equilibrium or steady state temperature.

The net energy loss between the heated polysilicon rod (32) and the cooled wall (30a) is modeled with the well known Stefan-Boltzmann law. For two concentric cylinders of equal surface areas the net energy transfer becomes:

$$q = \sigma \ A \ (T_1^4 \ - \ T_2^4) \ / \ (1/\varepsilon_1 + (1/\varepsilon_2 \ - \ 1)) \qquad\qquad (2)$$

where q = Thermal radiation emitted
σ = Stefan-Boltzmann constant
A = Surface area of the rod (32)
$T_1$ = Absolute temperature of the rod (32)
$T_2$ = Absolute temperature of the cooled wall (30a)
= Spectral emissivity of the rod (32)
$\varepsilon_2$ = Spectral emissivity of the cooled wall (30a).

As can be seen from Equation (2), because the net energy loss between the polysilicon rod (32) and the cooled wall (30a) is directly proportional to the 4th power temperature difference between them and because the temperature difference between the polysilicon rod (32) and the radiation shield (20) is lower than the temperature difference between the polysilicon rod (32) and the cooled wall (30a), the net energy loss from the heated polysilicon rod (32) is reduced by the addition of a "hot emitter" thermal radiation shield (20). As the thermal radiation emitted from the polysilicon rod (32) surface decreases (assuming constant energy input to the polysilicon rod (32)) the surface temperature of the polysilicon rod (32) increases. But because the Siemens CVD process requires a specific surface temperature of the polysilicon rod (32), a temperature-control-loop of the process acts to decrease the electrical energy input to the polysilicon rod (32) to maintain a constant surface temperature. Hence energy is conserved.

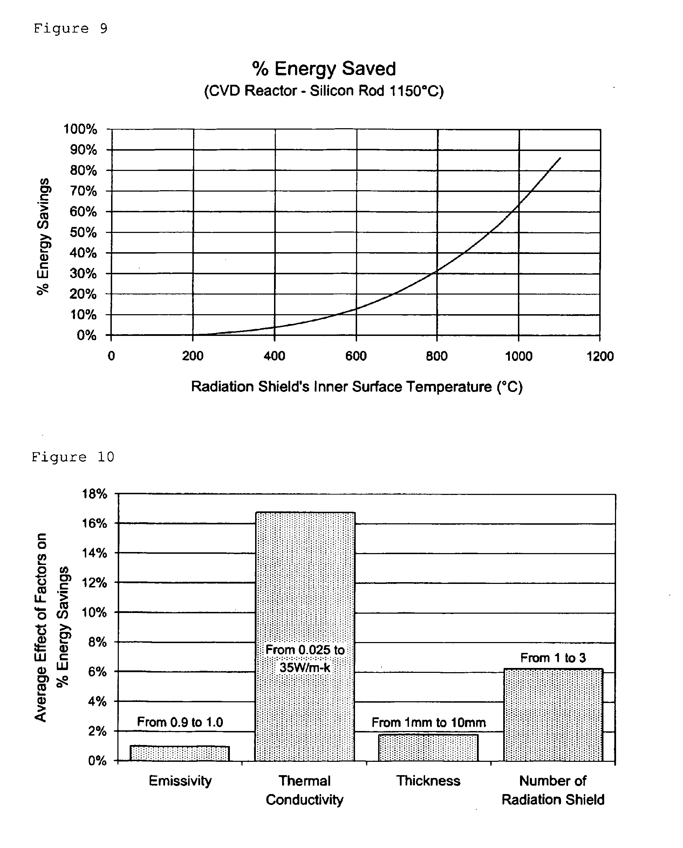

For a Siemens CVD reactor, the hot emitter thermal radiation shield (20) is most useful if its temperature is maintained at or above 400°C. Applying real numbers to the Stefan-Boltzmann law generates the graph of Fig. 9, which gives % energy savings as a function of innermost surface temperature of the radiation shield of Siemens CVD reactor device (100). According to the graph, the radiation shield (20) of the Siemens CVD reactor device (100) at 400°C reduces the thermal radiation energy loss from the heated polysilicon rods (32) by about 3.9%. The energy reduction must be by at least 4% for an 'effective' reduction effect. Therefore, in reducing the energy of the CVD reactor device (100), the inner temperature of the radiation shield (20) must be maintained at or above 400°C in order for the energy reduction to be effective. As illustrated in the graph, the energy reduction rate increases as the inner temperature of the radiation shield increases, such that the energy reduction rate is about 10% for an inner temperature of the radiation shield of about 550°C, and rises to about 64% for an inner temperature of 1000°C. Thus, it is preferable that the radiation shield (20) is formed and installed such that its inner surface temperature is maintained to be high.

A preferable way to maintain the inner surface temperature of a hot emitter thermal radiation shield (20) at a required high temperature is to provide a gap between the radiation shield (20) and the cooled wall (30a). The thermal radiant energy leaving the heated polysilicon rod (32) is absorbed by the thermal radiation shield (20) and causes the temperature of the radiation shield (20) to increase. If incoming energy flow to the radiation shield (20) is fixed, the final steady-state temperature of the thermal radiation shield (20) depends upon the rate at which its energy is lost. A gap between the thermal radiation shield (20) and the cooled wall (30a) stops energy loss of the radiation shield (20) by direct conduction to the cooled wall (30a). The gap distance is not important in blocking thermal conduction to the cooled wall. For example, a very minute gap such as 10μm can be meaningful.

The required hot surface of a hot-emitter thermal radiation shield (20) can be created by providing a shield that restricts conduction to the cooled wall (30a). If the radiation shield (20) is tightly pressed up against the cooled wall (30a) such that there is no gap resistance to conduction heat transfer between the thermal radiation shield (20) and the cooled wall (30a), a combination of thickness and low thermal conductivity of the radiation shield (20) can also restrict that energy loss from the thermal radiation shield (20) such that a temperature of the surface facing the heated polysilicon rod (32) is maintained above 400°C. Energy transfer through the thermal radiation shield (20) is represented by Fourier's Law of Conduction,

$$q = k/\tau \ A \ \Delta T \qquad\qquad (3)$$

where q = Energy transferred
k = thermal conductivity of material of the radiation shield (20)
A = Cross sectional area of heat transfer
ΔT = Temperature difference (front to back of radiation shield (20))
τ = Thickness of thermal radiation shield (20).

The term k/τ (that is, ratio of thermal conductivity (k) of material of the radiation shield to thickness (τ) of the

radiation shield) must be at or below about 3,000 Watt/Kelvin in order to effectively restrict heat transfer to the cooled wall (30a) such that the thermal radiation shield (20) temperature is maintained at or above 400°C.

As the energy generated within the heated polysilicon rod (32) due to resistive heating decreases (due to the presence of a thermal radiation shield (20)) and as the radiant energy losses at the rod (32) surface decrease, the radial temperature gradient in the polysilicon rod (32) also decreases. Assuming no conduction losses at the rod supports (39, 37, and 38), the heat-energy generated within the polysilicon rod (32) due to resistive heating must all be dissipated at the surface of the polysilicon rod (32) by thermal-radiation and convection. Fourier's Law of Conduction shows clearly that a decrease in energy transfer causes a decrease in radial temperature-gradient $\Delta T / \Delta r$) which reduction results in lower residual rod stresses after the polysilicon rods reach desired size and are cooled to room temperature.

Lower stresses allow increased diameters of polysilicon rod (32) and a corresponding increase in the production capacity of the Siemens reactor device (100). A production capacity of the Siemens reactor device (100) is limited by the available surface area of the rod filaments (34) or polysilicon rods (32) present within the process chamber (25). If one grows polysilicon rods (32) to a larger diameter, the average available surface area increases because rod surface area is linear with diameter. More area allows silicon bearing gas flow to increase into the process chamber (25) which in turn will be deposited in a form of polysilicon on the rod filaments (34) and finally result in a corresponding increase in average production capacity of the Siemens CVD reactor (100).

Also, a decreased thermal-gradient of the polysilicon rod (32) allows one at large diameters to operate the rod surface at a fixed optimum temperature of 1150°C (for the CVD decomposition of trichlorosilane, for example) without concerns that the center of the polysilicon rod (32) will reach melting point causing an early batch termination.

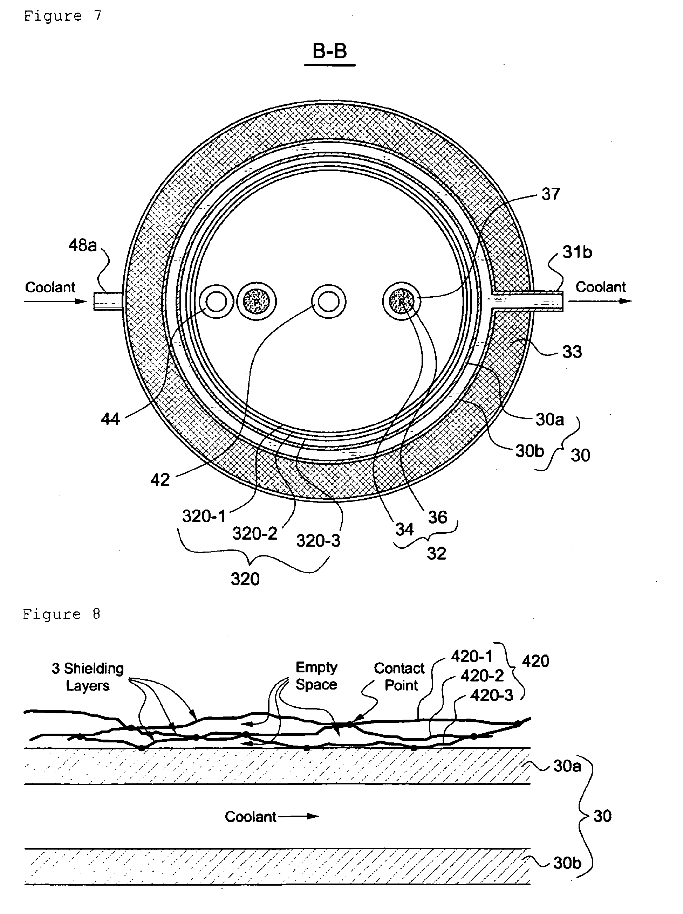

Multiple radiation shields (or multiple layers within a single shield) retain energy more efficiently than one single shield. Fig. 7 shows that three layers of radiation shields (320-1, 320-2 and 320-3) form a set of radiation shield (320) and covers sides of the cooled wall (30a). Each radiation shield (320-1, 320-2, 320-3) works as an additional layer of energy transfer resistance by absorbing and re-emitting energy back to the source. Each radiation shield (320-1, 320-2, 320-3) has two surfaces, the first surface oriented toward the radiant source (that is, toward the polysilicon rod (32)) and the opposite surface oriented toward the cooler target, the cooled wall (30a). Let's suppose that two radiation shields (320-1, 320-3) are placed between the polysilicon rod (32) and the cooled wall (30a) and the radiation shield-1 (320-1) is closest to the polysilicon rod (32) and radiation shield-3 (320-3) is closest to the cooled wall (30a). In this case, the radiation shield-3 (320-3) intercepts thermal radiant energy emanating from the radiation shield-1 (320-1). The temperature of radiation shield-3 (320-3) increases as it absorbs energy. As the temperature of radiation shield-3 (320-3) increases, the net energy transfer from the radiation shield-1 (320-1) to the radiation shield-3 (320-3) decreases according to the Stefan-Boltzmann law because the 4th power temperature difference between the radiation shields (320-1, 320-3) decreases. As in the above example each layer of the multiple shielding contributes independently to radiant energy interception, and thus the effect of multiple shielding increases as high as each layer decreases the total energy transfer. Therefore, it is preferable to use as many layers of thermal radiation shielding as possible.

If two radiation shields are tightly pressed against each other such that there is almost no gap (empty space) therebetween, the heat transfer between the radiation shields occurs via conduction (not thermal radiation) and they behave as if they were one shield. However, if two radiation shields are "loosely touching" each other such that numerous gaps exist between the layers, each layer behaves as a fraction of a shield or a partial shield. The radiation shield (420) shown in Fig. 8 is formed such that the layers of three radiation shields (420-1, 420-2, 420-3) are contacted at a certain locations (contact points) directly and a lot of gaps(empty space) are provided between the layers. Like this, it is convenient to use a multi-layer thermal-radiation shield (420) which is constructed by loosely laying multiple layers of shielding material together.

Also, the radiation shield may be installed so as to contact the cooled wall (30a). Fig. 8 shows that the radiation shield (420), more specifically the outermost layer of radiation shield (420-3), is contacted very loosely to a surface of the cooled wall (30a). In such a case, the radiation shield (420) loses energy by thermal conduction through the contacted portion to the cooled wall (30a), whereas the gap (empty space) between the portion not contacted to the cooled wall (30a) and the cooled wall (30a) allows heat transfer by radiation only, but blocks heat transfer by conduction. For example, when the thermal radiation shield (420-3) is occasionally touching the cooled wall (30a) such that surfaces touching comprise only 5% of the total shield surface area, the thermal energy is lost by conduction to the cooled wall (30a) but conduction heat transfer from the thermal radiation shield (420-3) to cooled wall (30a) would be restricted by about 95%.

A combination of the effects described above can also be effective at maintaining the thermal radiation shield at or above 400°C. For example, if the thermal radiation shield is touching the cooled wall (30a) but multiple gaps remain between the thermal radiation shield and the cooled wall (30a), energy losses via conduction will be limited. As shown in Fig. 8, if the three layers of radiation shield (420-1, 420-2, and 420-3) make a set of radiation shield (420) by a "loosely touching" or "lightly pressed touching" and the radiation shield (420) provides a lot of gaps against the cooled wall (30a), it can provide a good thermal shielding effect.

With a proper combination of substantial thickness and low thermal conductivity of a radiation shield such that $k/\tau$, the ratio of the substantial thickness to the thermal conductivity, is near or below 3,000 Watt/Kelvin, a loosely touching radiation shield can maintain itself at or above 400°C. For example, one may construct a loosely packed 100-layer shield that behaves as though it were made of 50 individual shields with full gaps between shields.

A thin radiation shield with material $k/\tau$ 3,000 Watt/Kelvin with multi-layers (or multiple-overlapped) pressed tightly against the cooled wall (30a), such that no gaps exist between the shield layers and between the radiation shield and the cooled wall (30a), behaves like no radiation shield exists because the radiation shield surface temperature is substantially same as that of the cooled wall (30a). Therefore for energy savings such a thermal-radiation shield should be either located in the gas space between the polysilicon rods (32) and the cooled wall (30a) (that is, installed so as not to touch the surface of the cooled wall (30a) directly) or it should be installed "loosely" attached to the cooled wall (30a) such that many gaps exist between the radiation shield and the cooled wall (30a), or it should be constructed with thickness and thermal conductivity such that $k/\tau$ < 3,000 Watt/Kelvin (in this case, the radiation shield may be installed to be pressed to the cooled wall (30a)), or it should be a thermal radiation shield that uses a combination of these design parameters.

If the shield material has considerable thickness and low thermal conductivity such that $k/\tau$ < 3,000 Watt/Kelvin, it may behave like a thermal insulator by restricting heat transfer through the thickness of the radiation shield. The overall effect is that the total thermal-radiant energy transferred is reduced. In such a case the incident surface of the radiation shield operates at a substantially higher temperature than the opposite surface.

The Stefan Boltzmann law shows that the spectral surface emissivity of the radiation shield affects the energy transfer. "Hot Emitter" thermal radiation shield materials with surface emissivities covering the whole range of 0.05 to 1.0 are efficient in inhibiting energy transfer. Those with lowest spectral surface emissivity are the most efficient because reflection occurs in one direction only while emittance occurs in two directions (both surfaces of the radiation shield).

On the other hand, critical for installing a radiation shield in a Siemens CVD reactor is that the radiation shield material be non-contaminating. At elevated temperature most materials will react, pyrolyze or outgas impurities. Graphite will slowly react with hydrogen at elevated temperatures forming methane gas and the addition of silicon-carbide as a coating over graphite comprises a hydrogen-impervious layer that eliminates or reduces the reaction between carbon and hydrogen. Hence, silicon carbide coated graphite is well suited as a thermal radiation shield material. Silicon carbide, silicon carbide coating over graphite, silicon, silicon coating over graphite, similar high purity materials, or their coatings over generic high temperature materials could be suitable for use as radiation shield materials in a Siemens CVD reactor. Those skilled in the art could choose from a wide variety of materials. For example, the radiation shield can be made of any one or combination of two or more selected from the group consisting of silicon nitrides (nitrified silicons), silicon oxides, aluminum oxides, boron nitrides, molybdenum or molybdenum-based alloys, tungsten or tungsten-based alloys, tantalum or tantalum-based alloys, silica-based porous materials, aluminosilicate-based porous materials, gold-coated porous materials, gold-coated any materials, platinum-coated porous materials, platinum-coated any materials, silica-coated porous materials, silica-coated any materials, silver-coated porous materials, silver-coated any materials, and perlite.

[Mode for Invention]

To demonstrate shield performance of the radiation shield, three examples are given and compared to a base-case, that is, to a conventional Siemens CVD reactor device shown in Fig. 1 without a radiation shield. The base-case consumes 133 kW of electrical energy continuously at 115mm rod diameter and the maximum rod-core temperature is 1233°C, for the conventional Siemens CVD reactor.

Embodiment 1:

A SiC-coated graphite thermal-radiation shield was placed between the heated rod filaments and the cooled wall of a Siemens CVD reactor. The 5mm thick radiation shield covered the entire surface of the cooled wall but did not cover the surface of the base plate. The radiation shield was positioned with a 100mm gap from the cooled wall. The spectral emissivity of the SiC coated graphite was considered to be 1.0. For a 115-mm diameter of polysilicon rod the total power consumption in the CVD reactor was 101kW resulting in 24% electrical energy savings compared to the base-case. The polysilicon rod-core temperature was 1194°C corresponding to a rod-core temperature decrease of 39°C from the base-case.

Embodiment 2:

A perlite thermal-radiation shield was placed between the rod filaments and the cooled wall of a Siemens CVD reactor. The 100mm thick radiation shield covered the entire surface of bell jar-shaped cooled wall, but did not cover the surface of the base plate. The radiation shield was positioned with a 5mm gap from the cooled wall. The spectral emissivity of the perlite was considered to be 0.9 and the perlite thermal conductivity was 0.029 W/mK. For a 115mm diameter of polysilicon rod, the total power consumption of the CVD reactor was 86 kW resulting in 35% electrical energy savings compared to the base-case. The polysilicon rod-core temperature was 1178°C corresponding to a rod-core temperature decrease of 54°C from the base-case.

Embodiment 3:

Three silicon thermal-radiation shields were placed between the rod filaments and the cooled wall of a Siemens CVD reactor.

The silicon shields were configured as shown in fig 4. The 5mm thick (ea) radiation shields covered the entire bell jar-shaped cooled wall, but did not cover the surface of the base plate. The radiation shields were positioned with a 5mm gap from the cooled wall. The spectral emissivity of the silicon was considered to be 0.9. For a 115mm diameter of polysilicon rod, the total power consumption of the CVD reactor was 52kW resulting in 61% electrical energy savings compared to the base case. The polysilicon rod-core temperature was 1145°C corresponding to a rod-core temperature decrease of 88°C from the base-case.

The heat shield effects mentioned above, such as heat shield by virtue of high temperature emittance (> 400°C), heat shield by multiple layers of radiation shield, heat shield by low emissivity spectral emittance of shield material and heat shield by thermal insulation due to a lowering of conduction through the thickness of the shield, are all additive regarding reducing the overall energy loss from the polysilicon rod (32). In order to check these unquantified effects in detail, calculations were performed to observe how much the spectral surface emittance, shield thickness, shield thermal conductivity, and number of layers of a radiation shield material affect the electrical energy reduction. The results of the calculations are the graph shown in Fig. 10. When the radiation shield is formed with 3 layers, the energy reduction rate is improved by about 6.4% compared to a case of just 1 layer. When the spectral surface emittance of the radiation shield material is increased from 0.9 to 1.0, the energy reduction rate is improved by about 1%. When the thickness of the radiation shield is increased from 1mm to 10mm, the energy reduction rate is improved by almost 2%. Also, when the thermal conductivity of the radiation shield material is changed from 0.025W/m-k to 35W/m-k, the energy reduction rate is increased by almost 17%. According to the calculations, for a radiation shield having a thickness of 1mm and a thermal conductivity of 35W/m-k, the energy reduction rate is below 4%. Therefore, it is preferable to make a radiation shield with material having a thermal conductivity below 35W/m-k.

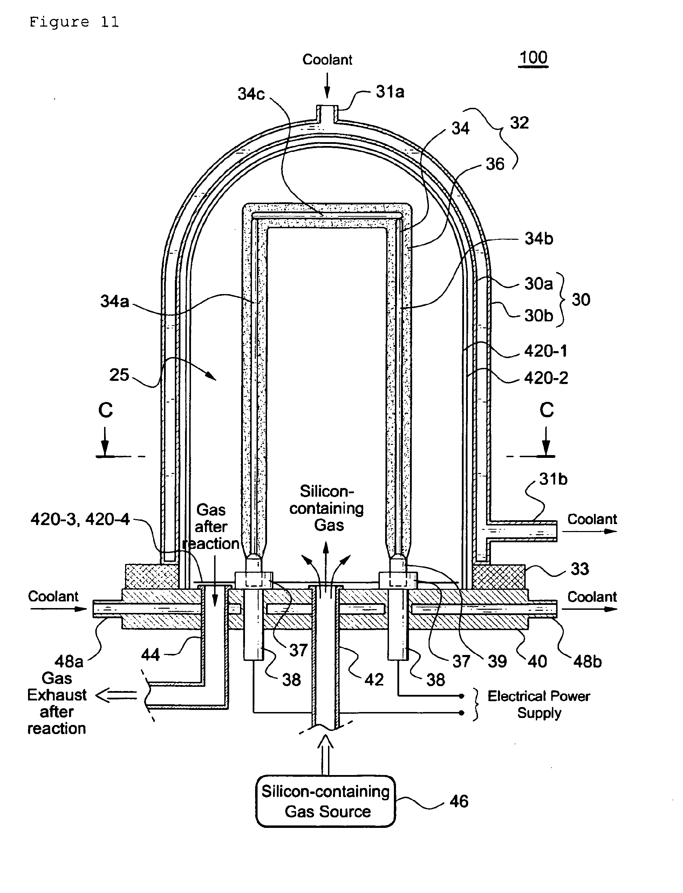

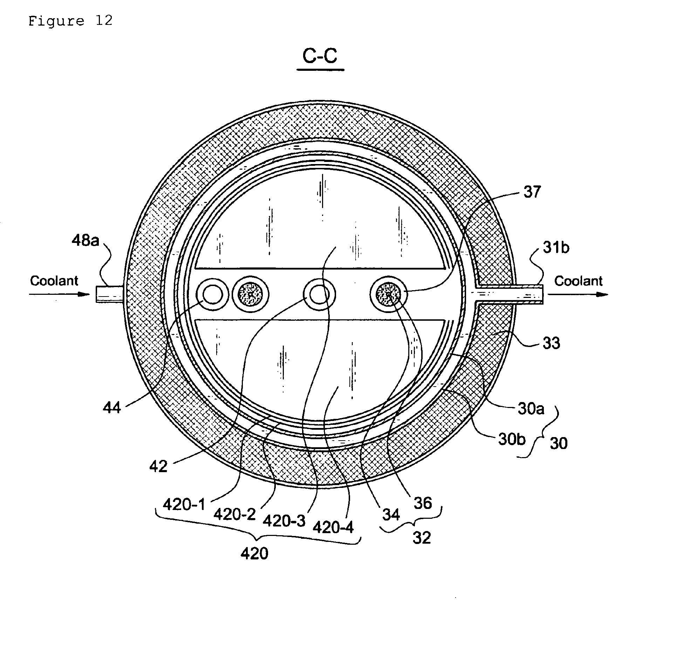

In the above embodiments a radiation shield is installed between a polysilicon rod (32) and a cooled wall (30a), but the radiation shield can be installed on a floor of a reaction chamber (25), that is, above a base plate (40). Since the thermal energy loss in the reaction chamber (25) can be reduced through the radiation shield covering the base plate (40), the net energy loss of the polysilicon rod (32) can be reduced much further. In the result, the energy reduction rate can be further raised, and the radial thermal gradient of the polysilicon rod (32) can be lowered. Figs. 11 and 12 show cases in which a radiation shield is installed not only between the polysilicon rod (32) and the cooled wall (30a), but also between the floor of the reaction chamber (25), that is, top of the base plate (40), and the polysilicon rod (32). As illustrated, the two-layered radiation shields (420-1, 420-2) are installed between the polysilicon rod (32) and the cooled wall (30a) covering the entire cooled wall (30a) except a part of the cooled wall (30a) (for observing inside of the reaction chamber (25) through a window (not shown) from outside), and as for the top side of the base plate (40) radiation shields (420-3, 420-4) can be installed so as to cover almost all area except for electrodes (39), rod support (37), gas inlet (42), and gas outlet (44). In order to minimize heat loss through conduction, the radiation shields (420-3, 420-4) are preferably installed so as not to touch directly the base plate (40), the electrodes (39) and the rod support (37) disposed on the base plate (40), and the gas inlet (42) and gas outlet (44).

[Industrial Applicability]

The present invention can be used to reduce electrical energy reduction of a Siemens CVD reactor, and at the same time to lower a temperature of center of a polysilicon rod.

**Claims**

1. A chemical vapor deposition (CVD) reactor device comprising:

a reaction container comprising one or more reaction chambers with a cooled wall;
a plurality of electrodes extending into the reaction chambers;
at least one rod filament having two ends connected to two different electrodes of the plurality of electrodes in the reaction chamber and being heated to a high temperature when an electrical current passes through the two electrodes;

a silicon-containing gas source that is connected to inside of the reaction chamber, supplies silicon-containing gas into the reaction chamber, and has polysilicon deposited on surfaces of the rod filament heated by a chemical vapor deposition (CVD) process producing polysilicon rod; and

a radiation shield disposed between the rod filament and the cooled wall and/or between the rod filament and the floor of the reaction chamber and shielding the radiant heat energy from the polysilicon rod from transferring to the cooled wall and/or to the floor of the reaction chamber.

2. The CVD reactor of Claim 1, wherein the temperature of the radiation shield and/or the temperature of a surface facing the heated polysilicon rod of the radiation shield is maintained above 400°C during a CVD reaction.

3. The CVD reactor of Claim 1, wherein the radiation shield is made to have thickness and thermal conductivity satisfying a condition of $k/\tau$ value below 3,000 Watt/Kelvin, where $k$ is a thermal conductivity of the radiation shield and $\tau$ is a thickness of the radiation shield.

4. The CVD reactor of Claim 1, wherein the silicon-containing gas is a silane gas source selected from the group consisting of monosilane, disilane, or chlorosilane, or mixture thereof.

5. The CVD reactor of Claim 1, wherein the radiation shield is made of any one or combination of two or more selected from the group consisting of silicon, graphite, silicon carbide(SiC), silicon carbide-coated material, silicon nitrides (nitrified silicons), silicon oxides, aluminum oxides, boron nitrides, molybdenum or molybdenum-based alloys, tungsten or tungsten-based alloys, tantalum or tantalum-based alloys, silica-based porous materials, aluminosilicate-based porous materials, gold-coated porous materials, gold-coated materials, platinum-coated porous materials, platinum-coated materials, silica-coated porous materials, silica-coated materials, silver-coated porous materials, silver-coated materials, and perlite.

6. The CVD reactor of Claim 1, wherein the radiation shield is installed so as to enclose the rod filament and to cover at least a part of surface of the cooled wall with respect to the cooled wall, and so as to cover at least a part of the floor with respect to the floor of the reaction chamber.

7. The CVD reactor of Claim 1, wherein the radiation shield comprises a plurality of radiation shields, and wherein the plurality of radiation shields are disposed with structures of, viewing from the rod filament toward the cooled wall, a) being disposed with two or more layers overlapped, b) being disposed with single layers with intervals therebetween, or c) being disposed with mixed structures of the overlapped multiple layers and the separated single layers.

8. The CVD reactor of Claim 1, wherein the radiation shield is formed by laminating a plurality of radiation shields, and wherein the plurality of radiation shields are overlapped loosely such that there exist multiple gaps between layers.

9. The CVD reactor of Claim 1, wherein the radiation shields are disposed with intervals such that a minimal minute gap is provided against the cooled wall so as to function as a thermal resistance.

10. The CVD reactor of Claim 1, wherein the radiation shields touch a surface of the cooled wall loosely such that a plurality of gaps are provided against the cooled wall.

11. The CVD reactor of Claim 1, wherein the radiation shield is made of material having a thermal conductivity below 35W/m-k.

12. The CVD reactor of Claim 3, wherein the radiation shield is installed pressed closely to the cooled wall such that there is no gap resistance to the thermal conductivity of the cooled wall.

13. The CVD reactor of Claim 1, wherein the radiation shield reduces the thermal energy loss from the polysilicon rod by at least one effect out of a thermal shielding effect by a hot re-radiation (higher than about 400°C), a shielding effect by multiple layers of radiation shields, a shielding effect by a low spectral emissivity of the radiation shield material, and an insulating effect by reduction of thermal conductivity due to thickness thereof.

14. The CVD reactor of Claim 1, wherein the radiation shield is made of material having a surface spectral emissivity from about 0.05 to about 1.0.

15. A chemical vapor deposition (CVD) reactor device comprising:

a reaction container forming a reaction chamber with a base plate and cooled wall covering the base plate;

an electrical power supply extending from outside of the reaction container into the reaction chamber through the base plate, being provided with a plurality of electrodes at end portions;

at least one rod filament having two ends connected to two different electrodes of the plurality of electrodes of the electrical power supply in the reaction chamber so as to form a closed circuit and being heated to a high temperature when an electrical current passes therein through the electrical power supply;

a silicon-containing gas source that supplies silicon-containing gas into the reaction chamber through a gas input pipe and a gas output pipe connected from outside to inside of the reaction chamber, and has polysilicon deposited on surfaces of the rod filament heated by a chemical vapor deposition (CVD) process producing polysilicon rod; and

a radiation shield disposed between the rod filament and the cooled wall and/or between the rod filament and the floor of the reaction chamber, covering at least a part of the cooled wall and/or a floor of the reaction chamber, and maintaining a temperature thereof above about 400°C by absorbing heat radiating from the polysilicon rod during the CVD reaction and reducing thermal energy loss of the polysilicon rod by re-radiating a part of the absorbed heat toward the polysilicon rod.

Figure 1

## Conventional Siemens CVD Reactor

Figure 2

Figure 3

## A-A

Figure 4

## A-A

Figure 5

Figure 6

## B-B

Figure 7

## B-B

Figure 8

Figure 9

## % Energy Saved
### (CVD Reactor - Silicon Rod 1150°C)

Figure 10

Figure 11

Figure 12

## C-C

Europäisches
Patentamt

European
Patent Office

Office européen
des brevets

**EUROPEAN SEARCH REPORT**

Application Number

EP 10 00 2031

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2001 294416 A (MITSUBISHI MATERIALS POLYCRYST; MITSUBISHI MATERIALS CORP) 23 October 2001 (2001-10-23) | 1-8, 10-15 | INV. C23C16/24 C23C16/44 |
| Y | * abstract * | 9 | C23C16/46 C01B33/035 |
| Y | US 3 340 848 A (ARNO KERSTING) 12 September 1967 (1967-09-12) * column 2, line 14 - line 29 * * column 3, line 42 - column 4, line 11 * | 9 | |
| X,P | DATABASE WPI Week 201007 Thomson Scientific, London, GB; AN 2010-A32733 XP002609233, & ES 2 331 283 A1 (CENT TECHNOLOGIA DEL SILICIO SOLAR SL) 28 December 2009 (2009-12-28) * abstract * | 1,15 | |
| | | | **TECHNICAL FIELDS SEARCHED (IPC)** C23C C01B |

The present search report has been drawn up for all claims

| Place of search | Date of completion of the search | Examiner |
|---|---|---|
| The Hague | 12 November 2010 | Ekhult, Hans |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT**
**ON EUROPEAN PATENT APPLICATION NO.**

EP 10 00 2031

This annex lists the patent family members relating to the patent documents cited in the above-mentioned European search report.
The members are as contained in the European Patent Office EDP file on
The European Patent Office is in no way liable for these particulars which are merely given for the purpose of information.

12-11-2010

| Patent document cited in search report | | Publication date | Patent family member(s) | | Publication date |
|---|---|---|---|---|---|
| JP 2001294416 | A | 23-10-2001 | NONE | | |
| US 3340848 | A | 12-09-1967 | BE | 666999 A | 17-01-1966 |
| | | | DE | 1540408 A1 | 02-01-1970 |
| | | | DE | 1229986 B | 08-12-1966 |
| | | | GB | 1062379 A | 22-03-1967 |
| | | | GB | 1110323 A | 18-04-1968 |
| ES 2331283 | A1 | 28-12-2009 | NONE | | |

EPO FORM P0459

For more details about this annex : see Official Journal of the European Patent Office, No. 12/82

**EP 2 330 232 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 3011877 A
- US 3147141 A
- US 3152933 A
- US 4173944 A
- US 6221155 B